(19) **Europäisches Patentamt**
**European Patent Office**
**Office européen des brevets**

(11) **EP 1 224 740 B1**

(12) **EUROPÄISCHE PATENTSCHRIFT**

(45) Veröffentlichungstag und Bekanntmachung des Hinweises auf die Patenterteilung:
**02.05.2003 Patentblatt 2003/18**

(51) Int Cl.⁷: $H03M\ 13/29$, $H03M\ 13/00$

(21) Anmeldenummer: **99957950.1**

(22) Anmeldetag: **27.10.1999**

(86) Internationale Anmeldenummer:
**PCT/DE99/03462**

(87) Internationale Veröffentlichungsnummer:
**WO 01/031795 (03.05.2001 Gazette 2001/18)**

(54) **VERFAHREN UND VORRICHTUNG ZUR CODIERUNG EINES PUNKTIERTEN TURBOCODE**

METHOD AND DEVICE FOR CODING A PUNCTURED TURBO CODE

PROCEDE ET DISPOSITIF POUR CODER UN TURBO-CODE PERFORE

(84) Benannte Vertragsstaaten:
**AT BE CH CY DE DK ES FI FR GB GR IE IT LI LU MC NL PT SE**

(43) Veröffentlichungstag der Anmeldung:
**24.07.2002 Patentblatt 2002/30**

(73) Patentinhaber: **Infineon Technologies AG**
**81669 München (DE)**

(72) Erfinder:
• **JUNG, Peter**
**D-67697 Otterberg (DE)**
• **PLECHINGER, Jörg**
**D-80469 München (DE)**

(74) Vertreter: **Barth, Stephan Manuel, Dr.**
**Reinhard-Skuhra-Weise & Partner Gbr,**
**Patentanwälte**
**Friedrichstrasse 31**
**80801 München (DE)**

(56) Entgegenhaltungen:
**US-A- 5 907 582**

• **FRANK BURKERT, GIUSEPPE CAIRE, JOACHM HAGENAUER, THOMAS HINDELANG, GUENTHER LECHNER: ""Turbo" decoding with unequal error protection applied to GSM speech " PROCEEDINGS OF GLOBECOM'96, 1996 IEEE GLOBAL TELECOMMUNICATIONS CONFERENCE , Bd. 3, 18. - 22. November 1996, Seiten 2044-2048, XP002133421 London (UK)**
• **BURR A G ET AL: "COMPARISON OF ITERATIVE DECODER PERFORMANCE WITH UNION BOUNDS FOR SHORT FRAME TURBO CODES" ANNALES DES TELECOMMUNICATIONS - ANNALS OF TELECOMMUNICATIONS,CH,PRE SSES POLYTECHNIQUES ET UNIVERSITAIRES ROMANDES, LAUSANNE, Bd. 54, Nr. 3/04, März 1999 (1999-03), Seiten 201-207, XP000834641 ISSN: 0003-4347**
• **ACIKEL O F ET AL: "High rate turbo codes for BPSK/QPSK channels" IEEE INTERNATIONAL CONFERENCE ON COMMUNICATIONS, CONFERENCE 5, Bd. 1, 1998, Seiten 422-427, XP002116627 New-York (US) ISBN: 0-7803-4789-7**
• **HINDELANG T ET AL: "USING POWERFUL TURBO CODES FOR 14.4 KBIT/S DATA SERVICE IN GSM OR PCS SYSTEMS" GLOBAL TELECOMMUNICATIONS CONFERENCE (GLOBECOM),US,NEW YORK, IEEE,1997, Seiten 649-653, XP000737619 ISBN: 0-7803-4199-6**

**Beschreibung**

Die Erfindung betrifft ein Codierverfahren und eine Codiervorrichtung zur Codierung eines seriellen Datenstroms mit sogenannten Turbo-Codes.

Durch die Codierung erfolgt eine Anpassung des Datenstroms von einer Informationsdatenquelle an ein Übertragungssystem zur Erhöhung der Sicherheit der Informationsübertragung gegenüber Störungen. Im Bereich des Mobilfunks ist der Übertragungskanal besonders starken Störungen ausgesetzt. Es wurde daher eine neue Klasse von Codierern entwickelt, die sogenannten Turbo-Codierer, die sich besonders zur Codierung von zu übertragenden Daten im Bereich des Mobilfunks eignen. Turbo-Codierer sind binäre verkettete Codiervorrichtungen, die aus mehreren verketteten Codierern bestehen. Dabei unterscheidet man seriell verkettet Turbo-Codierer sowie parallel verkettete Turbo-Codierer.

In "Turbo Decoding With Unequal Error Protection applied to GSM speech coding" von Burkert, Caire, Hagenauer in IEEEProceedings Of Globecom' 96, 18-11-1996, Band 3, Seiten 2044-2048 wird ein Turbo-Codierverfahren für ungleichen Fehlerschutz (UEP: Unequal Error Protection) beschrieben, bei dem ein Turbocode mit zwei Codierern $C_0$, $C_1$ und einem Verschachteler $\Pi$ codiert wird. Es ist dabei eine Punktierungseinrichtung zum Punktieren der codierten Datenströme vorgesehen, deren Punktierungsmuster an das Verschachtelungsdatenmuster zum Erreichen eines ungleichen Fehlerschutzes angepasst wird. Ein gleichmäßiger Fehlerschutz aller Datenbits eines angelegten zu codierenden seriellen Datenstroms wird bei den dort beschriebenen Turbo-Codierverfahren nicht erreicht.

In IEEE International Conference of Communications 1998, Band 1, Seiten 422-427 werden Hochgeschwindigkeits-Turbo-Codes für BPSK/QPSK-Kanäle beschrieben.

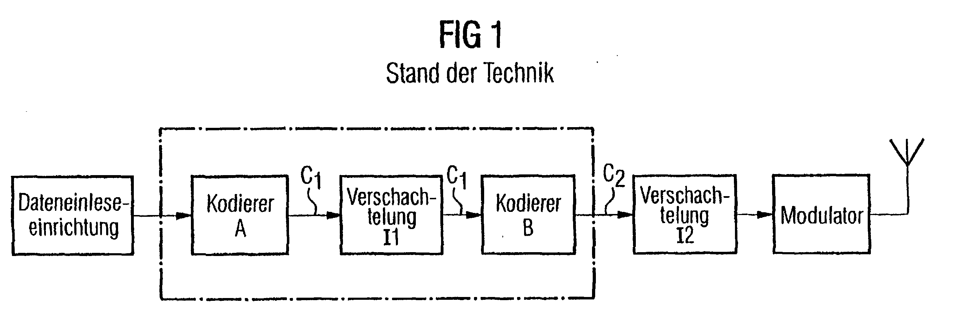

Fig. 1 zeigt den Aufbau einer seriell verketteten Turbo-Codiervorrichtung nach dem Stand der Technik. Ein von einer Informationsdatenquelle stammender serieller Datenstrom d wird einer Daten-Einleseeinrichtung zum Einlesen der Daten d zugeführt, die die Daten einliest und zu Datenrahmen vorbestimmter Länge codiert. Die Datenrahmen bzw. Datenblöcke gelangen in einen ersten Codierer A, der jedes Datum innerhalb des Datenrahmens entsprechend einer Codiervorschrift codiert und die codierten Daten als Code-Datenblock C1 an eine Verschachtelungsschaltung abgibt. Die Verschachtelungsschaltung verwürfelt den codierten Datenblock C1 entsprechend einer Verschachtelungs-Zuordnungsvorschrift, die in der Verschachtelungsschaltung abgespeichert ist. Die Verschachtelungs-Zuordnungsvorschrift bzw. Permutationsmatrix ordnet jeder Datenstelle innerhalb des Code-Datenblocks C1 eine bestimmte andere Datenstelle zu. Besteht der Code-Datenblock aus fünf Bits, wird durch die Verschachtelungsschaltung beispielsweise das Datum an der ersten Stelle des codierten Datenblocks C1 der ersten Stelle des verschachtelten Code-Datenblocks C1' zugeordnet, während beispielsweise das an der zweiten Stelle des Code-Datenblocks C1 gelegene Datenbit an die dritte Stelle des verschachtelten Code-Ausgangsdatenblocks C1' gesetzt wird.

Tabelle 1 zeigt ein Beispiel einer Verschachtelungszuordnung bzw. Interleaving-Vorschrift, bei der aus einer Eingangsdatenfolge entsprechend der Verschachtelungs-Zuordnungsvorschrift eine Ausgangsdatenfolge erzeugt wird.

Tabelle 1

| Eingangsdatenfolge | $x_1$ | $x_2$ | $x_3$ | $x_4$ | $x_5$ |
|---|---|---|---|---|---|
| Ausgangsdatenfolge | $x_1$ | $x_3$ | $x_4$ | $x_5$ | $x_2$ |

Wie man aus Tabelle 1 entnehmen kann, wird z.B. das an zweiter Stelle eingelesene Datenbit erst an der fünften Stelle des ausgegebenen Ausgangsdatenblocks ausgegeben.

Der verschachtelte codierte Datenblock C1' wird einem nachgeschalteten Codierer B zugeführt, der eine erneute Codierung zu einem codierten Datenblock C2 durchführt. Der codierte Datenblock C2 wird ebenfalls durch eine Verschachtelungsschaltung verschachtelt und über eine Modulationseinrichtung an eine Antenne zur Datenübertragung abgegeben. Der Codierer A wird auch als äußerer Codierer bezeichnet, während der Codierer B als innerer Codierer bezeichnet wird. Der Codierer A, die Verschachtelungsschaltung bzw. Interleaving-Schaltung II und der Codierer B bilden den eigentlichen Datenkanalcodierer.

Bei der seriell verketteten Turbo-Codiervorrichtung, wie sie in Fig. 1 dargestellt wird, erfolgt keine systematische Codierung, da die in dem ursprünglichen Datenstrom enthaltenen Daten nicht selbst übertragen werden, sondern lediglich codierte Daten übertragen werden.

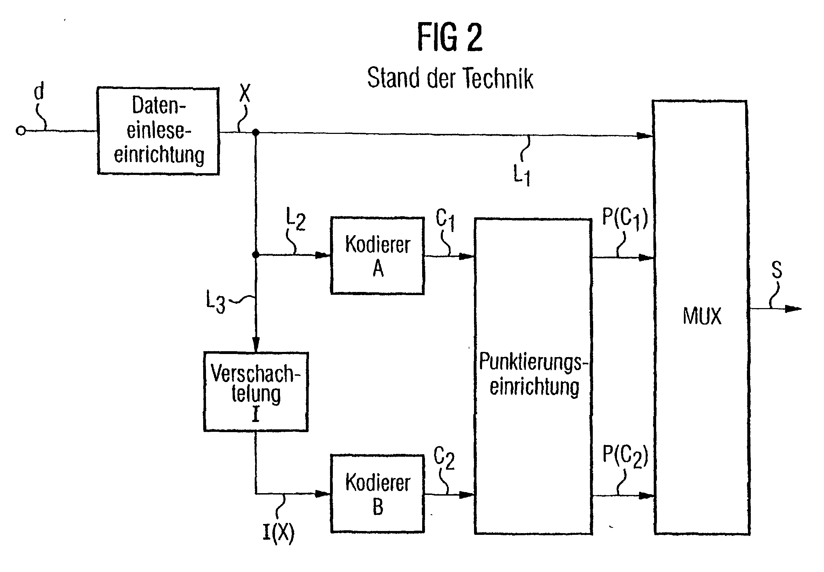

Bei der zweiten Gruppe von Turbo-Codierern, nämlich den parallel verketteten Codierern, erfolgt auch eine systematische Codierung. Fig. 2 zeigt den Aufbau eines parallel verketteten Turbo-Codierers nach dem Stand der Technik. Ein von einer Informationsdatenquelle stammender serieller Datenstrom mit seriellen Daten d wird durch eine Daten-Einleseeinrichtung eingelesen und zu Datenblöcken X gruppenweise zusammengefaßt. Jeder Datenblock X besteht aus mehreren Datenbits $x_i$. Die Daten-Einleseeinrichtung ist ausgangsseitig über eine Leitung L1 mit einem ersten Eingang eines Multiplexers verbunden. Ferner ist der Ausgang der Daten-Einleseeinrichtung über eine Leitung L2 mit dem Eingang eines ersten Codierers A verbunden, der den Datenblock X entsprechend einer Codiervorschrift zu einem codierten Datenblock $C_1$ codiert und an eine Punktierungseinrichtung abgibt. Ferner wird der am Ausgang der Daten-Einleseeinrichtung über eine Leitung L3 abgegebene Datenblock X durch eine Verschachtelungsschaltung I entsprechend einer vorgegebenen Permutationsmatrix verschachtelt bzw. umsortiert. Der verschachtelte Datenblock I(X) wird einem zweiten Codierer B zugeführt, der den verschachtelten Datenblock I(X) entsprechend einer Codierungsvorschrift zu einem Code-Datenblock $C_2$ codiert. Der codierte Datenblock $C_2$ wird ebenfalls der Punktierungseinrichtung P zugeführt.

Die Punktierungseinrichtung P verknüpft den codierten Datenblock $C_1$ und den codierten Datenblock $C_2$ jeweils mit einem zugehörigen Punktierungsdatenfeld. Die Punktierung durch die Punktierungseinrichtung P wird durchgeführt, um die Datenübertragungsrate zu erhöhen. Der punktierte codierte Datenblock P ($C_1$) und der punktierte Datenblock P ($C_2$) werden an Eingänge des Multiplexers angelegt, der den eingelesenen Datenblock X sowie die beiden punktierten Datenblöcke P($C_1$) sowie P($C_2$) zu einem Sendedatenblock S zeitmultiplext.

Im weiteren wird die genaue Funktionsweise des parallel verketteten Turbo-Codierers nach dem Stand der Technik, wie er in Fig. 2 dargestellt ist, anhand eines Beispiels zur Erläuterung der der Erfindung zugrunde liegenden Problematik beschrieben. Bei diesem Beispiel beträgt die Länge der Datenrahmen 5 Bit.

Von einer Datenquelle wird ein serieller Datenstrom durch die Daten-Einleseeinrichtung eingelesen und zu einem 5 Bit umfassenden Datenblock X codiert:

$$X = (x_1, x_2, x_3, x_4, x_5)$$

Der Codierer A codiert den eingelesenen Datenblock X entsprechend einer Codiervorschrift zu einem Code-Datenblock $C_1$:

$$C_1 = (c_{11}, c_{12}, c_{13}, c_{14}, c_{15})$$

Die Verschachtelungsschaltung I verschachtelt den eingelesenen Datenblock X beispielsweise entsprechend der folgenden Verschachtelungszuordnung:

Tabelle 2

| Eingang X | Ausgang I(x) |
|-----------|--------------|
| $x_1$ | $x_1$ |
| $x_2$ | $x_3$ |
| $x_3$ | $x_4$ |
| $x_4$ | $x_5$ |
| $x_5$ | $x_2$ |

Der verschachtelte bzw. interleavte Datenblock I(x) wird dem Codierer B zugeführt, der den verschachtelten Datenblock entsprechend einer Codiervorschrift zu einem codierten Datenblock $C_2$ codiert:

$$C_2 = (c_{21}, c_{22}, c_{23}, c_{24}, c_{25})$$

Die Punktierungseinrichtung P punktiert zur Erhöhung der Datenübertragungsrate den durch den Codierer A codierten Datenblock $C_1$ und den durch den Codierer B codierten Datenblock $C_2$ jeweils mit einem zugehörigen Punktierdatenfeld.

Das Punktierdatenfeld zur Punktierung des ersten codierten Datenblocks $C_1$ lautet:

$$P_1 = (10101)$$

Das Punktierdatenfeld zur Punktierung des zweiten codierten Datenblocks $C_2$ lautet:

$$P_2 = (01010)$$

Durch logische Verknüpfung des ersten codierten Datenblocks $C_1$ mit dem Punktierdatenfeld $P_1$ wird ein punktierter codierter Datenblock P ($C_1$) mit folgender Form erzeugt:

$$P(C_1) = (c_{11}, 0, c_{23}, 0, c_{25})$$

Durch Punktieren des zweiten codierten Datenblocks $C_2$ wird ein punktierter codierter Datenblock $P(C_2)$ erzeugt:

$$P(C_2) = (0, c_{22}, 0, c_{24}, 0)$$

Der Multiplexer Mux multiplext den eingelesenen Datenblock X sowie die beiden von der Punktiereinrichtung P abgegebenen punktierten und codierten Datenblöcke $P(C_1)$, $P(C_2)$ zu einem Sendedatenblock S.

Tabelle 3

| | |
|---|---|
| X = | $(x_1, x_2, x_3, x_4, x_5)$ |
| $P(C_1)$ = | $(c_{11}, 0, c_{13}, 0, c_{15})$ |
| $P(C_2)$ = | $(0, c_{22}, 0, c_{24}, 0)$ |
| S = | $(x_1, c_{11}, x_2, c_{22}, x_3, c_{13}, x_4, c_{24}, x_5, c_{15})$ |

Der Sendedatenblock S enthält einerseits einen systematischen Codier-Informationsgehalt, da die ursprünglichen eingelesenen Daten $x_1$, $x_2$, $x_3$, $x_4$, $x_5$ in den Sendedatenblock S enthalten sind, und andererseits enthält der Sendedätenblock S einen nicht systematischen Informationsgehalt aufgrund der codierten Daten c.

Die in Fig. 2 gezeigte parallel verkettete Turbo-Codiervorrichtung nach dem Stand der Technik hat jedoch den Nachteil, daß nicht zu jedem ursprünglichen Datenbit des eingelesenen Datenblocks X ein zugehöriges, nicht-systematisches codiertes Datenbit c als nicht-systematischer Informationsgehalt gesendet wird, wie aus folgender Tabelle ersichtlich wird:

Tabelle 4

| X | = $\boxed{x_1}$ | $x_2$ | $\boxed{x_3}$ | $x_4$ | $\boxed{x_5}$ |
|---|---|---|---|---|---|
| $C_1$ | = $c_{11}$ | $c_{12}$ | $c_{13}$ | $c_{14}$ | $c_{15}$ |
| $I(x)$ | = $x_1$ | $\boxed{x_3}$ | $x_4$ | $\boxed{x_5}$ | $x_2$ |
| $C_2$ | = $c_{21}$ | $c_{22}$ | $c_{23}$ | $c_{24}$ | $c_{25}$ |

Die im Sendedatenblock S enthaltenen codierten Datenbits $c_{11}$, $c_{22}$, $c_{13}$, $c_{24}$, $c_{15}$, die den nicht-systematischen Informationsgehalt des Sendedatenblocks S bilden, stellen codierte Datenbits der ursprünglichen Datenbits $x_1$, $x_3$, $x_3$, $x_5$ sowie $x_5$ dar. Für die ursprünglichen Datenbits $x_2$ und $x_4$ werden keine codierten Datenbits c in dem Sendedatenblock S enthalten. Die ursprünglichen Datenbits $x_2$, $x_4$ werden lediglich systematisch übertragen. Durch das Fehlen der codierten Datenbits für die ursprünglichen Daten $x_2$ sowie $x_4$ ist der nicht-systematische Informationsgehalt des Sendedatenblocks S niedriger als in einem Fall, bei dem zu jedem Informationsdatenbit x ein entsprechendes codiertes Datenbit c übertragen wird. Dementsprechend steigt das Bit-Fehlerverhältnis BFV mit abnehmenden nicht-systematischem Informationsgehalt innerhalb des Sendedatenblocks S an.

Es ist daher die Aufgabe der vorliegenden Erfindung, ein Codierverfahren und eine Codiervorrichtung zum Codieren eines seriellen Datenstroms zu schaffen, bei dem der nicht-systematische Informationsgehalt des codierten Sendedatenstroms maximal ist.

Diese Aufgabe wird erfindungsgemäß durch ein Codierverfahren mit den im Patentanspruch angegebenen Merkmalen sowie durch eine Codiervorrichtung mit den im Patentanspruch 6 angegebenen Merkmalen gelöst.

Die Erfindung schafft ein Codierverfahren zur Codierung eines seriellen Datenstroms mit den folgenden Schritten:

Codieren eines von einer Datenquelle empfangenen Datenstroms mittels mindestens einem Codierer zu einem codierten Datenstrom;

Verschachteln des von der Datenquelle empfangenen Datenstroms entsprechend vorbestimmter Verschachtelungszuordnungen zu mindestens einem Verschachtelungsdatenstrom;

Codieren der Verschachtelungsdatenströme mittels zugehöriger Codierer zu codierten Verschachtelungsdatenströmen; Punktieren der codierten Datenströme und der codierten Verschachtelungsdatenströme durch Verknüpfen mit zugehörigen Punktierdatenfeldern ($p_1$, $P_2$),

wobei das Punktierdatenfeld ($P_2$) zum Punktieren eines codierten Verschachtelungsdatenstroms vor dem Verknüpfen mittels derjenigen Verschachtelungszuordnung verschachtelt wird, mit der der codierte Verschachtelungsdatenstrom verschachtelt ist;

Multiplexen des von der Datenquelle abgegebenen Datenstroms und der punktierten Datenströme zu einem Sendedatenstrom,

wobei zu jedem Datenbit ($x_i$) des empfangenen Datenstroms ein codiertes Datenbit als nicht-systematischer Codierungsinhalt des Sendedatenstroms übertragen wird.

Vorteilhafte Ausgestaltungen des erfindungsgemäßen Verfahrens sind in den nachgeordneten Unteransprüchen angegeben.

Der von der Datenquelle abgegebene serielle Datenstrom wird vorzugsweise blockweise zum Codieren eingelesen.

Bei einer bevorzugten Weiterbildung wird die Verschachtelungszuordnung zum Verschachteln des Punktierungsdatenfeldes aus der zugehörigen Verschachtelungsschaltung ausgelesen.

Die Verschachtelungszuordnung wird vorzugsweise eingestellt.

Bei einer bevorzugten Weiterbildung erfolgt das Punktieren durch logisches Verknüpfen eines Datenstroms mit einem Punktierungsdatenfeld mittels einer Logikschaltung.

Die Erfindung schafft ferner eine Codiervorrichtung zur Codierung eines seriellen Datenstroms mit einem Dateneingang zum Anlegen des aus einer Folge von Datenbits bestehenden seriellen Datenstroms;

mindestens einem mit dem Dateneingang verbundenen Codierer zum Codieren des Datenstroms zu einem codierten Datenstrom; mindestens einer mit dem Dateneingang verbundenen Verschachtelungsschaltung zum Verschachteln des Datenstroms zu einem Verschachtelungsdatenstrom entsprechend einer Verschachtelungszuordnung, wobei der Verschachtelungsdatenstrom durch einen der Verschachtelungsschaltungen nachgeschalteten Codierer zu einem codierten Verschachtelungsdatenstrom codiert wird; einer Punktiereinrichtung zum Punktieren des codierten Datenstroms und des codierten Verschachtelungsdatenstroms mittels einer jeweiligen Punktierschaltung zum Verknüpfen des Datenstroms mit einem Punktierdatenfeld zu punktierten Datenströmen, wobei die Punktiereinrichtung eine Punktier-Verschachtelungsschaltung aufweist, die das Punktierdatenfeld zum Punktieren des codierten Verschachtelungsdatenstroms entsprechend der zugehörigen Verschachtelungszuordnung verschachtelt und an die Punktierschaltung zu Verknüpfung mit dem codierten Verschachtelungsdatenstrom abgibt; und mit einem Multiplexer zum Multiplexen des seriellen Datenstroms und der von der Punktiereinrichtung abgegebenen punktierten Datenströme zu einem Sendedatenstrom, wobei sich jedem Datenbit des an den Dateneingang angelegten Datenstroms ein codiertes Datenbit als nicht-systematischer Codierungsinhalt des Sendedatenstroms übertragen wird.

Bei einer bevorzugten Weiterbildung der erfindungsgemäßen Codiervorrichtung ist die Punktier-Verschachtelungsschaltung mit der zugehörigen Verschachtelungsschaltung über eine Ausleseleitung zum Auslesen der Verschachtelungszuordnung verbunden.

Die Verschachtelungsschaltungen weisen vorzugsweise jeweils einen Speicher zum Abspeichern der Verschachtelungszuordnungen auf.

Bei einer bevorzugten Weiterbildung ist die Verschachtelungszuordnung in den Verschachtelungsschaltungen jeweils über eine Einstelleitung einstellbar.

Bei einer bevorzugten Ausführungsform der erfindungsgemäßen Codiervorrichtung sind die Punktierungsdatenfelder jeweils in Speichern der Punktiereinrichtung abspeicherbar.

Vorzugsweise sind die Punktierungsdatenfelder jeweils über Einstelleitungen einstellbar.

Vorzugsweise ist die Punktierschaltung eine Logikschaltung zur logischen Verknüpfung des Datenstroms mit dem Punktierdatenfeld.

Gemäß einer bevorzugten Weiterbildung enthält das Punktierdatenfeld mehrere Datenelemente, die jeweils einen logischen hohen H-Zustand oder einen logisch niedrigen L-Zustand einnehmen.

Die erfindungsgemäße Codiervorrichtung weist gemäß einer bevorzugten Ausführungsform eine Daten-Einleseeinrichtung auf, die den am Dateneingang liegenden seriellen Datenstrom zur Abgabe von Datenblöcken mit bestimmter Länge einliest.

Die Länge der Datenblöcke ist dabei vorzugsweise einstellbar.

Gemäß einer weiteren bevorzugten Weiterbildung sind die Codierer rekursive systematische Faltungscodierer.

Im weiteren wird eine bevorzugte Ausführungsform des erfindungsgemäßen Codierverfahrens und der erfindungsgemäßen Codiervorrichtung unter Bezugnahme auf die beigefügten Zeichnungen zur Erläuterung erfindungswesentlicher Merkmale beschrieben.

Es zeigen:

Fig. 1 einen seriell verketteten Turbo-Codierer nach dem Stand der Technik;

Fig. 2 einen parallel verketteten Turbo-Codierer nach dem' Stand der Technik;

Fig. 3 eine erfindungsgemäße Codiervorrichtung zur Codierung eines seriellen Datenstroms.

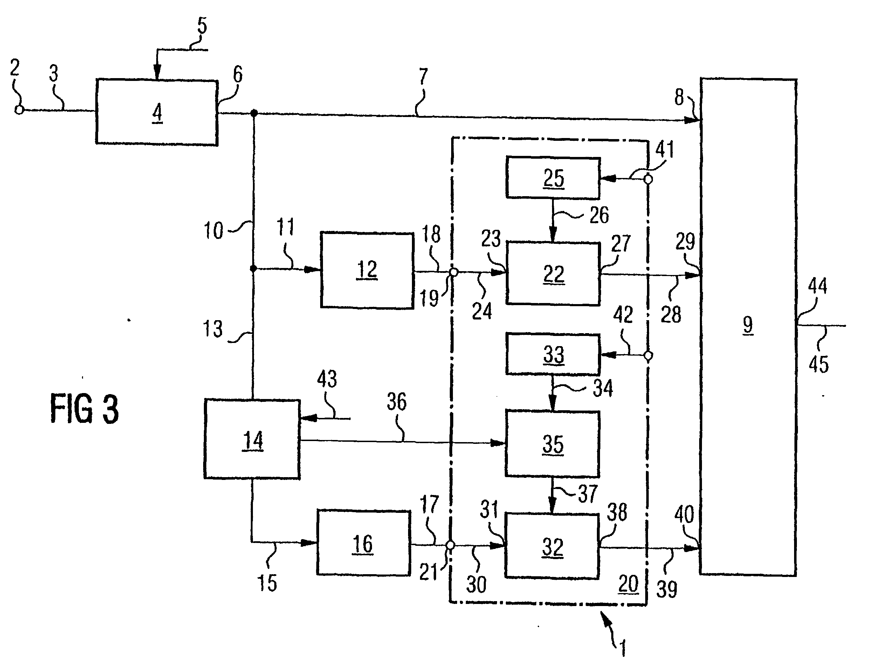

Die in Fig. 3 dargestellte erfindungsgemäße Codiervorrichtung 1 zur Codierung eines seriellen Datenstroms weist einen Dateneingang 2 auf, an dem ein von einer Informationsdatenquelle abgegebener serieller Datenstrom anliegt. Der serielle Datenstrom wird über eine Leitung 3 einer Daten-Einleseeinrichtung 4 zugeführt, die die seriellen Daten einliest und zu Datenblöcken gruppiert. Die Länge der Datenblöcke bzw. Datenrahmen ist über eine Einstelleitung 5 einstellbar. Der Signalausgang 6 der Daten-Einleseeinrichtung 4 gibt die Datenblöcke über eine Leitung 7 an einen ersten Signaleingang 8 eines Multiplexers 9 ab. Die Datenblöcke am Signalausgang 6 der Daten-Einleseeinrichtung 4 werden ferner über interne Leitungen 10, 11 einem ersten Codierer 12 zur Codierung mit einer ersten vorbestimmten Codiervorschrift zugeführt. Ferner gelangen die an dem Signalausgang 6 der Daten-Einleseeinrichtung 4 gegebenen Datenblöcke über interne Leitungen 10, 13 zu einer Verschachtelungsschaltung 14, die diejenigen in dem Datenblock enthaltenen Daten entsprechend einer Verschachtelungszuordnung mittels einer abgespeicherten Permutationsmatrix verschachtelt bzw. umsortiert und den verschachtelten Datenblock ausgangsseitig über eine Leitung 15 an einen zweiten Codierer 16 abgibt. Der Codierer 16 codiert den an der Leitung 15 anliegenden verschachtelten Datenstrom bzw. den anliegenden verschachtelten Datenblock entsprechend einer vorbestimmten Codiervorschrift zu einem codierten Verschachtelungsdatenstrom, der über eine Leitung 17 abgegeben wird.

Der von dem Codierer 12 codierte Datenstrom wird über eine Ausgabeleitung 18 einem ersten Signaleingang 19 einer Punktiereinrichtung 20 zugeführt. Die Punktiereinrichtung 20 weist einen weiteren Signaleingang 21 auf, der an die Ausgabeleitung 17 des Codierers 16 zum Empfang des codierten Verschachtelungsdatenstroms angeschlossen ist.

Die Punktiereinrichtung 20 enthält eine erste Punktierungsschaltung 22, deren Eingang 23 über eine Signalleitung 24 an den Signalleitungsanschluß 19 der Punktiereinrichtung 20 angeschlossen ist. Die Punktierschaltung 22 punktiert den von dem Codierer 12 empfangenen codierten Datenstrom mit einem Punktierungsdatenfeld, das in einem ersten Speicher 25 der Punktierungseinrichtung 20 abgespeichert ist. Die Punktierungsschaltung 22 verknüpft das in dem Punktierungsdatenfeldspeicher 25 abgespeicherte Punktierungsdatenfeld, indem sie das Punktierungsdatenfeld über eine Leitung 26 aus dem Speicher 25 ausliest und mittels einer Logikschaltung bitweise mit dem codierten Datenstrom am Signaleingang 23 logisch verknüpft. Das in dem Punktierungsdatenfeldspeicher 25 abgespeicherte Punktierungsdatenfeld weist mehrere Datenelemente auf, die jeweils einen logischen hohen H-Zustand oder einen logisch niedrigen L-Zustand einnehmen. Die in dem Punktierungsdatenfeld enthaltenen Datenelemente werden vorzugsweise in einer logischen UND-Verknüpfung mit dem am Signaleingang 23 anliegenden codierten Datenstrom bitweise verknüpft. Hierzu wird jedes Datenbit des am Signaleingang 23 anliegenden Datenblocks bzw. Datenrahmens mit einem entsprechenden Datenelement des Punktierungsdatenfeldes logisch UND-verknüpft. Die Punktierung des codierten Datenstroms durch die Punktierungsschaltung 22 dient zur Erhöhung der Übertragungsbitrate. Der punktierte codierte Datenstrom wird an einen Signalausgang 27 der Punktierungsschaltung 22 abgegeben und wird über eine Leitung 28 an einen zweiten Signaleingang 29 des Multiplexers 9 angelegt.

Der am Signaleingang 21 der Punktierungseinrichtung 20 anliegende codierte Verschachtelungsdatenstrom wird über eine interne Leitung 30 zu einem Signaleingang 31 einer zweiten in der Punktierungseinrichtung 20 enthaltenen Punktierungsschaltung 32 zugeführt. Das in einem zweiten Punktierungsdatenfeldspeicher 33 der Punktierungseinrichtung 20 abgespeicherte Punktierungsdatenfeld wird über eine Leitung 34 in eine Punktierungs-Verschachtelungsschaltung 35 eingelesen und dort mit einer Verschachtelungszuordnung verschachtelt bzw. umsortiert, die mit derjenigen Verschachtelungszuordnung der Verschachtelungsschaltung 14 identisch ist. Hierzu ist die Verschachtelungsschaltung 35 vorzugsweise über eine Ausleseleitung 36 mit der Verschachtelungsschaltung 14 zum Auslesen der zugehörigen Verschachtelungszuordnung verbunden. Die in die Verschachtelungsschaltung 35 der Punktierungseinrichtung 20 über die Leseleitung 36 eingelesene Verschachtelungs-Zuordnungsvorschrift wird auf das in dem Punktierungsdatenfeldspeicher abgespeicherte Punktierungsdatenfeld angewendet und gelangt als verschachteltes Punktierungsdatenfeld über eine Leitung 37 zu der Punktierungsschaltung 32, die den am Signaleingang 31 anliegenden codierten Verschachtelungsdatenstrom mit dem verschachtelten Punktierungsdatenfeld logisch zur Abgabe eines punktierten codierten Verschachtelungsdatenstroms an einen Signalausgang 38 der Punktierungsschaltung 32 verknüpft. Der codierte und durch die Punktierungsschaltung 32 punktierte Verschachtelungsdatenstrom gelangt über eine Leitung 39 zu einem dritten Signaleingang 40 des Multiplexers 9.

Die in den beiden Punktierungsdatenfeldspeichern 25, 33 abgespeicherten Punktierungsdatenfelder sind vorzugsweise über Einstelleitungen 41, 42 einstellbar. Ferner wird bei einer , bevorzugten Ausführungsform die Verschachtelungszuordnung über eine Einstelleitung 43 in die Verschachtelungsschaltung 14 eingegeben. Der Multiplexer 9 multiplext die an den Signaleingängen 8, 29, 40 anliegenden Datenströme, d.h. den am Signaleingang 8 anliegenden seriellen Datenstrom, den am Signaleingang 29 anliegenden codierten und durch die Punktierschaltung 22 punktierten seriellen Datenstrom .sowie den am Signaleingang 40 anliegenden, codierten verschachtelten und durch die Punktierschaltung 32 punktierten seriellen Datenstrom, so daß an dem Signalausgang 44 des Multiplexers 9 ein Sendedatenstrom S über eine Signalleitung 45 abgegeben wird.

Der nicht-systematische Informationsgehalt ist bei der in Fig. 3 gezeigten erfindungsgemäßen Codiervorrichtung maximal, so daß das Bitfehlerverhältnis bei Übertragung des Sendedatenstroms S über einen Übertragungskanal minimal wird.

Dies wird aus dem nachfolgenden Beispiel deutlich.

Es wird durch die Daten-Einleseeinrichtung 4 beispielsweise ein aus fünf Bits bestehender Datenblock X eingelesen.

$$X = (x_1, x_2, x_3, x_4, x_5)$$

Durch den Codierer 12 wird der eingelesene Datenblock X durch eine vorgegebene Codiervorschrift zu einem codierten Datenblock $C_1$ codiert.

$$C_1 = (c_{11}, c_{12}, c_{13,} c_{14}, c_{15})$$

Durch die Verschachtelungsschaltung 14 wird der Datenblock X entsprechend einer Verschachtelungszuordnung verschachtelt bzw. interleavt.

Tabelle 2

| Eingang X | Ausgang I(x) |
|-----------|--------------|
| $x_1$ | $x_1$ |
| $x_2$ | $x_3$ |
| $x_3$ | $x_4$ |
| $x_4$ | $x_5$ |
| $x_5$ | $x_2$ |

Der Codierer 16 codiert den durch die Verschachtelungsschaltung entsprechend der Verschachtelungszuordnung verschachtelten Datenblock entsprechend einer vorgegebenen Codierungsvorschrift zu einem codierten verschachtelten Datenblock $C_2$.

$$C_2 = (c_{21}, c_{22}, c_{23}, c_{24}, c_{25})$$

In dem Punktierungsdatenfeldspeicher 25 ist ein erstes Punktierungsdatenfeld $P_1$ abgespeichert.

$$P_1 = (10101)$$

In dem Punktierungsdatenfeldspeicher 33 ist ein zweites Punktierungsdatenfeld $P_2$ abgespeichert.

$$P_2 = (01010)$$

Die Verschachtelungsschaltung 35 liest die in der Verschachtelungsschaltung 14 zwischengespeicherte Verschachtelungszuordnung aus und verschachtelt die in dem Punktierungsdatenfeldspeicher 33 abgespeicherten Datenelemente des Punktierungsdatenfeldes entsprechend dieser Verschachtelungszuordnung zu einem verschachtelten Punktierungsdatenfeld $I(P_2)$.

Tabelle 5

| $P_2$ | $I(P_2)$ |
|---|---|
| 0 | 0 |
| 1 | 0 |
| 0 | 1 |
| 1 | 0 |
| 0 | 1 |

Die Punktierungsschaltung 32 verknüpft das verschachtelte Punktierungsdatenfeld $I(P_2)$ mit dem am Signaleingang 31 anliegenden codierten Verschachtelungsdatenblock $C_2$ zu einem punktierten Datenstrom $P_2'(C_2)$, wobei $P'_2 = I(P_2)$.

Mit $I(P_2) = (0, 0, 1, 0, 1)$ und mit $C_2 = (c_{21}, c_{22}, c_{23}, c_{24}, c_{25})$ ergibt sich ein punktierter codierter Verschachtelungsdatenstrom $P_2'(C_2)$ am Signalausgang 38 der Punktierungsschaltung 32 von:
$(0, 0, c_{23}, 0, c_{25})$

Somit liegen an den Signaleingängen 8, 29, 40 folgende Datenblöcke an:

Tabelle 6

| Signaleingang 8 | $x_1, x_2, x_3, x_4, x_5$ |
|---|---|
| Signaleingang 29 | $c_{11}, 0, c_{13}, 0, c_{15}$ |
| Signaleingang 40 | $0, 0, c_{23}, 0, c_{25}$ |

Der Multiplexer 9 multiplext die drei an den Signaleingängen 8, 29, 40 anliegenden seriellen Daten zu einem Sendedatenstrom S.
$S = x_1, c_{11}, x_2, x_3, c_{13}, c_{23}, x_4, x_5, c_{15}, c_{25}$

Wie man aus der nachfolgenden Tabelle erkennen kann, wird zu jedem ursprünglichen Datenbit $x_i$ des eingelesenen Datenblocks X ein codiertes Datenbit c als nicht-systematischer Codierungsinhalt des Sendedatenstroms übertragen.

## Tabelle 7

| X | $= \boxed{X_1}$ | $X_2$ | $\boxed{X_3}$ | $X_4$ | $\boxed{X_5}$ |
|---|---|---|---|---|---|
| $C_1$ | $= C_{11}$ | $C_{12}$ | $C_{13}$ | $C_{14}$ | $C_{15}$ |

------------------------------------------

| $I(X)$ | $= X_1$ | $X_3$ | $\boxed{X_4}$ | $X_5$ | $\boxed{X_2}$ |
|---|---|---|---|---|---|
| $C_2$ | $= C_{21}$ | $C_{22}$ | $C_{23}$ | $C_{24}$ | $C_{25}$ |

So wird das codierte Datenbit $c_{11}$ aus dem ursprünglichen Datenbit $x_1$, das codierte Datenbit $c_{13}$ aus dem ursprünglichen Datenbit $x_3$, das codierte Datenbit $c_{23}$ aus dem ursprünglichen Datenbit $x_4$, das codierte Datenbit $c_{15}$ aus dem ursprünglichen Datenbit $x_5$ und das codierte Datenbit $c_{25}$ aus dem ursprünglichen Datenbit $x_2$ generiert. Der

nicht-systematische Codierungsinhalt des Sendedatenblocks S ist somit maximal, wodurch das Bitfehlerverhältnis bei Übertragungen des Sendedatenblocks S über einen Übertragungskanal minimal wird.

Bei der erfindungsgemäßen Codiervorrichtung wird die Maximierung des nicht-systematischen Codierungsinhalts innerhalb des Sendedatenblocks durch die Kopplung der Punktiereinrichtung 20 mit der Verschachtelungsschaltung 14 erreicht, aus der die Verschachtelungszuordnung über die Leitung 36 zur Verschachtelung des Punktierungsdatenfeldes $P_2$ ausgelesen wird.

Die Punktierung des seriellen Datenstroms kann für verschiedene Datenbit-Folgen des Datenstroms unterschiedlich sein. Der von der Datenquelle empfangene Datenstrom wird blockweise zum weiteren Codieren eingelesen. Der eingelesene Datenblock X kann dabei mehrere nacheinander folgende Datenfolgen $X_1$, $X_2$ mit unterschiedlicher Bedeutung bzw. Wichtigkeit besitzen. Eine erste Datenfolge $X_1$ des eingelesenen Datenblocks X enthält dabei beispielsweise Informationen, die im Vergleich zu der Information einer weiteren Datenfolge $X_2$ des eingelesenen Datenblocks X von höherer Bedeutung sind. Um eine störungsfreie Datenübertragung zu gewährleisten, werden daher die Datenbits der Datenfolge $X_1$ vorzugsweise mit einer niedigeren Coderate geschützt als die weniger bedeutenden Datenbits der Datenfolge $X_2$ des eingelesenen Datenblocks X. Dies wird mit einem Punktierungsdatenfeld P erreicht, das eine erste Punktierungs-Datenelementfolge $P_a$, deren Datenelemente sich sämtlich in einem logischen H-Zustand befinden, und das eine zweite Punktierungs-Datenelementfolge $P_b$ aufweist, deren Datenelemente sich abwechselnd in einem logisch hohen H-Zustand und in einem logisch niedrigen L-Zustand befinden. Die Datenbits der ersten Datenfolge $X_1$ des eingelesenen Datenblocks X werden so durch die erste Punktierungs-Datenelementfolge $P_a$ des Punktierungsdatenfeldes P nicht punktiert, wodurch sich zusammen mit den systematischen Bits eine Coderate von 1/3 für diese bedeutenden Datenbits ergibt. Durch die alternierende Punktierung der nachfolgenden Datenfolge $X_2$ des Datenblocks X mittels der zweiten Punktierungs-Datenelementfolge $P_b$ wird jeweils genau ein nicht systematisches Bit zusammen mit einem systematischen Bit übertragen, so daß sich eine Coderate von ½ ergibt.

Aufgrund der ungleichen Punktierung der verschiedenen Datenfolgen des seriellen Datenstroms wird ein ungleicher Fehlerschutz (unequal error protection) realisiert, bei der die bedeutenden Datenbits $x_1$ durch eine niedrige Coderate besonders geschützt werden. Durch die einfache Erzeugung eines ungleichen Fehlerschutz für Datenfolgen $X_1$, die wichtige Informationen enthalten, und Datenfolgen $X_2$, die weniger wichtige Informationen enthalten, ist es möglich für beide Datenfolgen den gleichen Decodierer zu verwenden.

Der ungleiche Fehlerschutz wird somit schaltungs-technisch in sehr einfacher Weise gewährleistet. Darüber hinaus ist der ungleichmäßige Fehlerschutz bei der erfindungsgemäßen Codiervorrichtung besonders flexibel, da die in den Punktierungsdatenfeldern 25, 33 abgespeicherten Punktierungsdatenfelder P über die Einstellleitungen 41, 42 entsprechend einem bekannten Datenfolgen-Formates des seriellen Datenstroms flexibel einstellbar sind.

Bezugszeichenliste

1    Codiervorrichtung
2    Dateneingang
3    Leitung
4    Dateneinleseeinrichtung
5    Einstelleitung
6    Signalausgang
7    Leitung
8    Signaleingang des Multiplexers
9    Multiplexer
10   Leitung
11   Leitung ,
12   Codierer
13   Leitung
14   Verschachtelungsschaltung
15   Leitung
16   Codierer
17   Leitung
18   Leitung
19   Signaleingang der Punktierungseinrichtung
20   Punktierungseinrichtung
21   Signaleingang der Punktierungseinrichtung
22   Punktierungsschaltung

23 Signaleingang der Punktierungsschaltung
24 Leitung
25 Punktierungsdatenfeldspeicher
26 Leitung
27 Signalausgang der Punktierungsschaltung
28 Leitung
29 Signaleingang des Multiplexers
30 Leitung
31 Signaleingang der Punktierungsschaltung
32 Punktierungsschaltung
33 Punktierungsdatenfeldspeicher
34 Leitung
35 Punktierungs-Verschachtelungsschaltung
36 Ausleseleitung
37 Leitung
38 Signalausgang der Punktierungsschaltung
39 Leitung
40 Signaleingang des Multiplexers
41 Einstelleitung
42 Einstelleitung
43 Einstelleitung
44 Signalausgang des Multiplexers
45 Sendesignalleitung

**Patentansprüche**

1. Codierverfahren zur Codierung eines seriellen Datenstroms mit den folgenden Schritten:

   (a) Codieren eines von einer Datenquelle empfangenen Datenstroms (X), der aus einer Folge von Datenbits $(x_i)$ besteht, mittels Codierer (12) zu codierten Datenströmen;

   (b) Verschachteln des von der Datenquelle empfangenen Datenstroms (X) entsprechend vorbestimmter Verschachtelungszuordnungen (I) zu Verschachtelungsdatenströmen mittels Verschachtelungsschaltungen (14);

   (c) Codieren der Verschachtelungsdatenströme mittels zugehöriger Codierer (16) zu codierten Verschachtelungsdatenströmen;

   (d) Punktieren der codierten Datenströme und der codierten Verschachtelungsdatenströme durch Verknüpfen mit zugehörigen vorbestimmten Punktierungsdatenfeldern ($P_1$, $P_2$),
   wobei das Punktierungsdatenfeld ($P_2$) zum Punktieren eines codierten Verschachtelungsdatenstroms vor dem Verknüpfen entsprechend derjenigen Verschachtelungszuordnung (I) verschachtelt wird, mit welcher der codierte Verschachtelungsdatenstrom verschachtelt ist, wobei das Codierverfahren **gekennzeichnet ist durch**:

   (e) Multiplexen des von der Datenquelle abgegebenen Datenstroms und der punktierten Datenströme zu einem Sendedatenstrom, wobei zu jedem Datenbit (x) des empfangenen Datenstroms ein codiertes Datenbit als nicht-systematischer Codierungsinhalt des Sendedatenstroms übertragen wird.

2. Codierverfahren nach Anspruch 1,
   **dadurch gekennzeichnet,**
   **daß** der von der Datenquelle empfangene Datenstrom (X) blockweise zum weiteren Codieren eingelesen wird.

3. Codierverfahren nach Anspruch 1 oder 2,
   **dadurch gekennzeichnet,**
   **daß** die Verschachtelungszuordnung (I) zum Verschachteln des Punktierungsdatenfeldes (P) aus der zugehörigen Verschachtelungsschaltung (14) ausgelesen wird.

4. Codierverfahren nach einem der vorangehenden Ansprüche,

**dadurch gekennzeichnet,**
**daß** die Verschachtelungszuordnung (I) eingestellt wird.

5. Codierverfahren nach einem der vorangehenden Ansprüche,
**dadurch gekennzeichnet,**
**daß** das Punktieren durch logisches Verknüpfen eines Daten-Stroms mit einem Punktierungsdatenfeld (P) mittels einer Logikschaltung erfolgt.

6. Codiervorrichtung zur Codierung eines seriellen Datenstroms mit:

(a) einem Dateneingang (2) zum Anlegen des aus einer Folge von Datenbits bestehenden seriellen Datenstroms;

(b) mindestens einem mit dem Dateneingang (2) verbundenen Codierer (12) zum Codieren des Datenstroms zu einem codierten Datenstrom;

(c) mindestens einer mit dem Dateneingang (2) verbundenen Verschachtelungsschaltung (14) zum Verschachteln des Datenstroms zu einem Verschachtelungsdatenstrom entsprechend einer Verschachtelungszuordnung,
wobei der Verschachtelungsdatenstrom durch einen der Verschachtelungsschaltung (14) nachgeschalteten Codierer (16) zu einem codierten Verschachtelungsdatenstrom codiert wird;

(d) einer Punktierungseinrichtung (20) zum Punktieren des codierten Datenstroms und des codierten Verschachtelungsdatenstroms mittels einer jeweiligen Punktierungsschaltung (22, 32) durch Verknüpfen des Datenstroms mit einem Punktierungsdatenfeld zu punktierten Ausgangsdatenströmen, wobei die Punktierungseinrichtung (20) eine Punktierungs-Verschachtelungsschaltung (35) aufweist, die das Punktierungsdatenfeld zum Punktieren des codierten Verschachtelungsdatenstroms entsprechend der zugehörigen Verschachtelungszuordnung verschachtelt und an die Punktierungsschaltung (32) zur Verknüpfung mit dem codierten Verschachtelungsdatenstrom abgibt,
**gekennzeichnet durch**

(e) einen Multiplexer (9) zum Multiplexen des seriellen Datenstroms und der von der Punktierungseinrichtung (20) abgegebenen punktierten Datenströme zu einem Sendedatenstrom, wobei zu jedem Datenbit ($x_i$) des an den Dateneingang (2) angelegten Datenstroms ein codiertes Datenbit als nicht-systematischer Codierungsinhalt des Sendedatenstroms übertragen wird.

7. Codiervorrichtung nach Anspruch 6,
**dadurch gekennzeichnet,**
**daß** die Punktierungs-Verschachtelungsschaltung (35) mit der zugehörigen Verschachtelungsschaltung (14) über eine Ausleseleitung (36) zum Auslesen der Verschachtelungszuordnung verbunden ist.

8. Codiervorrichtung nach Anspruch 6 oder 7,
**dadurch gekennzeichnet,**
**daß** die Verschachtelungsschaltung (14) einen Speicher zum Abspeichern der Verschachtelungszuordnung aufweist.

9. Codiervorrichtung nach einem der vorangehenden Ansprüche,
**dadurch gekennzeichnet,**
**daß** die Verschachtelungszuordnung über eine Einstelleitung (43) einstellbar ist.

10. Codiervorrichtung nach einem der vorangehenden Ansprüche,
**dadurch gekennzeichnet,**
**daß** die Punktierungsdatenfelder jeweils in Speichern (25, 33) der Punktierungseinrichtung (20) abspeicherbar sind.

11. Codiervorrichtung nach einem der vorangehenden Ansprüche,
**dadurch gekennzeichnet,**
**daß** die Punktierungsdatenfelder über Einstelleitungen (41, 42) einstellbar sind.

**12.** Codiervorrichtung nach einem der vorangehenden Ansprüche,
**dadurch gekennzeichnet,**
**daß** die Punktierungsschaltung (22, 32) eine Logikschaltung zur logischen Verknüpfung des Datenstroms mit dem Punktierungsdatenfeld ist.

**13.** Codiervorrichtung nach einem der vorangehenden Ansprüche,
**dadurch gekennzeichnet,**
**daß** eine Dateneinleseeinrichtung (4) vorgesehen ist, die den am Dateneingang (2) anliegenden seriellen Datenstrom zur Abgabe von Datenblöcken mit vorbestimmter Länge einliest und gruppiert.

**14.** Codiervorrichtung nach einem der vorangehenden Ansprüche,
**dadurch gekennzeichnet,**
**daß** die Länge der Datenblöcke einstellbar ist.

**15.** Codiervorrichtung nach einem der vorangehenden Ansprüche,
**dadurch gekennzeichnet,**
**daß** die Codierer (12, 16) rekursive systematische Faltungscodierer sind.

**16.** Codiervorrichtung nach einem der vorangehenden Ansprüche,
**dadurch gekennzeichnet,**
**daß** das Punktierungsdatenfeld mehrere Datenelemente enthält, die sich jeweils in einem logischen hohen H-Zustand oder einem logisch niedrigen L-Zustand befinden.

**17.** Codiervorrichtung nach einem der vorangehenden Ansprüche
**dadurch gekennzeichnet,**
**daß** das Punktierungsdatenfeld mehrere unterschiedliche Datenelementfolgen zur Punktierung verschiedener Datenfolgen des seriellen Datenstroms aufweist.

**18.** Codiervorrichtung nach einem der vorangehenden Ansprüche,
**dadurch gekennzeichnet,**
**daß** das Punktierungsdatenfeld eine erste Datenelementfolge deren Datenelemente sich in einerm logisch hohen H-Zustand zur Punktierung einer ersten Datenfolge des seriellen Datenstroms befinden, und eine zweite Datenelementfolge aufweist, deren Datenelemente sich abwechselnd in einem logisch hohen H-Zustand und einem logisch niedrigen L-Zustand zur Punktierung einer zweiten Datenfolge des seriellen Datenstroms befinden.

**Claims**

**1.** Coding method for coding a serial data stream, having the following steps:

(a) a data stream (X), comprising a sequence of data bits ($X_1$), received from a data source is coded using coders (12) to form coded data streams;

(b) the data stream (X) received from the data source is interleaved on the basis of predetermined interleaving associations (I) to form interleaved data streams using interleaving circuits (14);

(c) the interleaved data streams are. coded using associated coders (16) to form coded interleaved data streams;

(d) the coded data streams and the coded interleaved data streams are punctured by logic combination with associated predetermined puncturing data fields ($P_1$ $P_2$),
the puncturing data field ($P_2$) for puncturing a coded interleaved data stream being interleaved before logic combination on the basis of that interleaving association (I) which was used to interleave the coded interleaved data stream, the coding method being **characterized by**:

(e) the data stream output by the data source and the punctured data streams are multiplexed to form a transmission data stream, a coded data bit being transmitted as nonsystematic coding content of the transmission data stream for each data bit (x) and of the received data stream.

2. Coding method according to Claim 1,
**characterized**
**in that** the data stream (X) received from the data source is read in block by block for the purposes of further coding.

3. Coding method according to Claim 1 or 2,
**characterized**
**in that** the interleaving association (I) for interleaving the puncturing data field (P) is read from the associated interleaving circuit (14).

4. Coding method according to one of the preceding claims,
**characterized**
**in that** the interleaving association (I) is set.

5. Coding method according to one of the preceding claims,
characterized
puncturing is effected by logically combining a data stream with a puncturing data field (P) using a logic circuit.

6. Coding apparatus for coding a serial data stream, having

(a) a data input (2) for applying the serial data stream comprising a sequence of data bits;

(b) at least one coder (12), connected to the data input (2), for coding the data stream to form a coded data stream;

(c) at least one interleaving circuit (14), connected to the data input (2), for interleaving the data stream to form an interleaved data stream on the basis of an interleaving association, (16), connected downstream of the interleaving circuit (14), to form a coded interleaved data stream;

(d) a puncturing device (20) for puncturing the coded data stream and the coded interleaved data stream using a respective puncturing circuit (22, 32) by logically combining the data stream with a puncturing data field to form punctured output data streams, the puncturing device (20) having a puncturing interleaving circuit (35) which interleaves the puncturing data field for puncturing the coded interleaved data stream on the basis of the associated interleaving association and outputs it to the puncturing circuit (32) for logic combination with the coded interleaved data stream, charaterized by

(e) a multiplexer (9) for multiplexing the serial data stream and the punctured data streams output by the puncturing device (20) to form a transmission data stream, a coded data bit being transmitted as nonsystematic coding content of the transmission data stream for each data bit $(x_i)$ of the data stream applied to the data input (2).

7. Coding apparatus according to Claim 6,
**characterized**
**in that** the puncturing interleaving circuit (35) is connected to the associated interleaving circuit (14) by means of a read line (36) for reading the interleaving association.

8. Coding apparatus according to Claim 6 or 7,
**characterized**
**in that** the interleaving circuit (14) has a memory for storing the interleaving association.

9. Coding apparatus according to one of the preceding claims,
**characterized**
**in that** the interleaving association can be set using a setting line (43).

10. Coding apparatus according to one of the preceding claims,
**characterized**
**in that** the puncturing data fields can each be stored in memories (25, 33) in the puncturing device (20).

**11.** Coding apparatus according to one of the preceding claims,
**characterized**
**in that** the puncturing data fields can be set using setting lines (41, 42).

**12.** Coding apparatus according to one of the preceding claims,
**characterized**
**in that** the puncturing circuit (22, 32) is a logic circuit for logically combining the data stream with the puncturing data field.

**13.** Coding apparatus according to one of the preceding claims,
**characterized**
**in that** a data read-in device (4) is provided which reads in and groups the serial data stream applied to the data input (2) in order to output data blocks of predetermined length.

**14.** Coding apparatus according to one of the preceding claims,
**characterized**
**in that** the length of the data blocks can be set.

**15.** Coding apparatus according to one of the preceding claims,
**characterized**
**in that** the coders (12, 16) are recursive systematic convolutional coders.

**16.** Coding apparatus according to one of the preceding claims,
**characterized**
**in that** the puncturing data field contains a plurality of data elements which are respectively in a logic high H-state or a logic low L-state.

**17.** Coding apparatus according to one of the preceding claims,
**characterized**
**in that** the puncturing data field has a plurality of different data element sequences for puncturing various data sequences of the serial data stream.

**18.** Coding apparatus according to one of the preceding claims,
**characterized**
**in that** the puncturing data field has a first data element sequence, whose data elements are in a logic high H-state for puncturing a first data sequence of the serial data stream, and a second data element sequence, whose data elements are alternately in a logic high H-state and a logic low L-state for puncturing a second data sequence of the serial data stream.

**Revendications**

**1.** Procédé de codage pour coder un flux de données en série avec les étapes suivantes :

(a) codage d'un flux de données (X) provenant d'une source de données, constituée d'une suite de bits de données ($x_i$), à l'aide d'un codeur (12) en flux de données codés ;
(b) entrelacement du flux de données provenant de la source de données (X) selon des allocations d'entrelacement (I) prédéterminées en flux de données d'entrelacement à l'aide de circuits d'entrelacement (14) ;
(c) codage des flux de données d'entrelacement à l'aide de codeurs (16) correspondants en flux de données d'entrelacement codé ;
(d) ponctuation des flux de données codés et des flux de données d'entrelacement codé par combinaison avec des champs de données de ponctuation ($P_1$, $P_2$) associés prédéterminés, le champ de données de ponctuation ($P_2$), pour la ponctuation d'un flux de données d'entrelacement codé, étant entrelacé avant la combinaison selon l'allocation d'entrelacement (I) avec la quelle le flux de données d'entrelacement codé est entrelacé, le procédé de codage étant **caractérisé par**
(e) le multiplexage du flux de données généré par la source de données et des flux de données ponctués en un flux de données d'émission, un bit de données codé étant transmis en tant que contenu de codage non systématique du flux de données d'émission pour chaque bit de données (x) du flux de données reçu.

**2.** Procédé de codage selon la revendication 1, **caractérisé en ce que** le flux de données (X) provenant de la source de données est entré en blocs pour un codage ultérieur.

**3.** Procédé de codage selon la revendication 1 ou 2, **caractérisé en ce que** l'allocation d'entrelacement (I) est extraite du circuit d'entrelacement (14) associé pour l'entrelacement du champ de données de ponctuation (P).

**4.** Procédé de codage selon l'une des revendications précédentes, **caractérisé en ce que** l'allocation d'entrelacement (I) peut être ajustée.

**5.** Procédé de codage selon l'une des revendications précédentes, **caractérisé en ce que** la ponctuation est réalisé par combinaison logique d'un flux de données avec un champ de données de ponctuation (P) à l'aide d'un circuit logique.

**6.** Dispositif de codage pour coder un flux de données en série comprenant :

(a) une entrée de données (2) pour entrer le flux de données constitué d'une suite de bits de données ;
(b) au moins un codeur (12) relié à l'entrée de données (2) pour le codage du flux de données en un flux de données codé ;
(c) au moins un circuit d'entrelacement (14) relié à l'entrée de données (2) pour l'entrelacement du flux de données en un flux de données d'entrelacement selon une allocation d'entrelacement, le flux de données d'entrelacement étant codé par un codeur (16), branché en aval du circuit d'entrelacement (14), en un flux de données d'entrelacement codé ;
(d) un dispositif de ponctuation (20) pour ponctuer le flux de données codé et le flux de données d'entrelacement codé à l'aide d'un circuit de ponctuation (22, 32) respectif par combinaison du flux de données avec un champ de données de ponctuation en des flux des données de sortie, le dispositif de ponctuation (20) comportant un circuit d'entrelacement et de ponctuation (35) qui entrelace le champ de données d'entrelacement pour la ponctuation du flux de données d'entrelacement codé selon l'allocation d'entrelacement associé et qui l'envoie au circuit de ponctuation (32) pour le combiner avec le flux de données d'entrelacement codé, **caractérisé par**
(e) un multiplexeur (9) pour le multiplexage du flux de données en série et des flux de données ponctués générés par le dispositif de ponctuation (20) en un flux de données d'émission, un bit de données codé étant transmis, en tant que contenu de codage non systématique du flux de données d'émission, pour chaque bit de donnée ($x_i$) du flux de données appliqué à l'entrée de données (2).

**7.** Dispositif de codage selon la revendication 6, **caractérisé en ce que** le circuit d'entrelacement et de ponctuation (35) est relié, par l'intermédiaire d'une ligne d'extraction (36), au circuit d'entrelacement (14) associé pour l'extraction de l'allocation d'entrelacement.

**8.** Dispositif de codage selon la revendication 6 ou 7, **caractérisé en ce que** le circuit d'entrelacement (14) comporte une mémoire pour stocker l'allocation d'entrelacement.

**9.** Dispositif de codage selon l'une des revendications précédentes, **caractérisé en ce que** l'allocation d'entrelacement peut être réglée par l'intermédiaire d'une ligne de réglage (43).

**10.** Dispositif de codage selon l'une des revendications précédentes, **caractérisé en ce que** les champs de données de ponctuation peuvent être stockés dans des mémoires (25, 33) du dispositif de ponctuation (20).

**11.** Dispositif de codage selon l'une des revendications précédentes, **caractérisé en ce que** les champs de données de ponctuation peuvent être ajustés par l'intermédiaire de lignes de réglages (41, 42).

**12.** Dispositif de codage selon l'une des revendications précédentes, **caractérisé en ce que** le circuit de ponctuation (22, 32) est un circuit logique pour la combinaison logique du flux de données avec le champ de données de ponctuation.

**13.** Dispositif de codage selon l'une des revendications précédentes, **caractérisé en ce qu'**un dispositif d'entrée de données (4) est prévu pour entrer et regrouper le flux de données en série, appliqué à l'entrée de données (2), afin de générer des blocs de données d'une longueur prédéterminée.

**14.** Dispositif de codage selon l'une des revendications précédentes, **caractérisé en ce que** la longueur des blocs de données peut être ajustée.

**15.** Dispositif de codage selon l'une des revendications précédentes, **caractérisé en ce que** les codeurs (12, 16) sont des codeurs de convolution systématiques récursifs.

**16.** Dispositif de codage selon l'une des revendications précédentes, **caractérisé en ce que** le champ de données de ponctuation contient plusieurs éléments de données qui se trouvent dans un état logique haut H ou dans un état logique bas L.

**17.** Dispositif de codage selon l'une des revendications précédentes, **caractérisé en ce que** le champ de données de ponctuation comporte plusieurs suites d'éléments de données différentes pour la ponctuation de différentes suites de données du flux de données en série.

**18.** Dispositif de codage selon l'une des revendications précédentes, **caractérisé en ce que** le champ de données de ponctuation comporte une première suite d'éléments de données dont les éléments de données se trouvent dans un état logique haut H pour la ponctuation d'une première suite de données du flux de données en série et une deuxième suite d'éléments de données dont les éléments de données se trouvent alternativement dans un état logique haut H et dans un état logique bas L pour la ponctuation d'une deuxième suite de données du flux de données en série.

# FIG 1
## Stand der Technik

# FIG 2

Stand der Technik

FIG 3

EP 1 224 740 B1